# EUROPEAN PATENT SPECIFICATION

(11) **EP 1 974 225 B1**
(45) Date of publication and mention of the grant of the patent: **03.07.2019**
(21) Application number: 07705049.0
(22) Date of filing: 26.01.2007
(51) Int. Cl.: G01R 23/165

(54) **SIGNAL ANALYSER**
SIGNALANALYSATOR
ANALYSEUR DE SIGNAL

(30) Priority: 28.01.2006 GB 0601761
(43) Date of publication of application: 01.10.2008
(73) Proprietor: Gadideas Limited, Chipping Norton, Oxfordshire OX7 5HA (GB)
(72) Inventor: SIMPSON, Martin, Paul, Oxfordshire OX7 5HA (GB)
(74) Representative: Turner, Richard Charles
(86) International application number: PCT/GB2007/000281
(87) International publication number: WO 2007/085853

(56) References cited:
- EP-A- 0 977 384
- US-A- 5 706 202

## Description

The invention relates to a method and system for processing a signal.

It is known that all signals comprise at least one sinusoidal signal. Such signals, which may be of any frequency range (for example sub-sonic, audio, video, radio, radar, light, x-rays, gamma rays usually within a frequency band from within the range of mHz to EHz), often need to be analysed, measured, and/or identified, for example, so that characteristics of the signals may be identified, and/or data compressed for example.

Existing signal analysis methods, such as Fourier analysis and FFT (Fast Fourier Transform), provide a measure of frequencies within an input signal within a time window, which means that sinusoidal signals within the input signal cannot be identified and measured to a very fine time resolution. Additionally, signals of a transient or impact nature cause broad band frequency information within the window that is not localised in time and smears the sinusoidal information.

US 5,706,202 discloses a frequency spectrum analyzing apparatus and transmitter characteristics measuring apparatus using the same and EP 0977384 discloses a method and apparatus for measuring spectral energy of mobile handset.

The use of multiple band pass filters to process a signal is known. For example, GB 2034056 discloses a spectrum display apparatus. In the apparatus, a plurality of band-pass filters divide an input signal into frequency bands, each band being supplied to a respective holding circuit for holding the level of the signal in the corresponding frequency band in response to a control signal. A display is provided with sections for displaying the signal levels of the corresponding frequency bands received from the holding circuits. A control switch is provided for actuating means for producing the control signal for a predetermined time period. The holding circuits are normally inoperative and the display displays the instantaneous levels of the signal in the frequency bands. When the control switch is operated, the holding circuits hold the levels in the frequency bands and the display displays these held levels for the predetermined time period, whereafter, the apparatus reverts automatically to the display of the instantaneous levels.

The apparatus of this document displays the amplitude levels of a plurality of frequency bands within the received signal. This is a relatively simple analysis of only a small proportion of the components within the received signal, and cannot be used for anything other than a very unsophisticated analysis of the incoming signal.

It is therefore an object of the invention to improve upon the known art.

According to a first aspect of the present invention, there is provided a method according to claim 1.

According to a second aspect of the present invention, there is provided a system according to claim 8.

Owing to the invention, it is possible to provide a method of processing a signal that reveals the components of the signal in fine and accurate detail. The invention provides the capability to determine the presence of, and changes of, sinusoidal signals at very high time resolution. In addition the invention provides the capability to determine the frequency of sinusoidal signals to a highly accurate frequency resolution. In addition the invention provides the capability to discriminate the multiple sinusoidal signals to a high degree of accuracy. Phase information about the sinusoidal signals in the received signal is also obtainable. The methodology can be used to detect periodic components within a signal, and can also be used to detect impact components in a signal. For example, in an audio signal, a hand clap would be an impact component, and this can also be identified using the technique of extracting local peaks from the output of the band pass filters.

A principal advantage of the invention is that both frequency and temporal information are at the same resolution. With, for example, Fast Fourier Transform, there is increased temporal resolution at the expense of not having a great deal of frequency information (smaller window, limited lowest frequency), or increased lower frequency information (larger window) and smeared higher frequency time information (e.g. During the last 1024 samples the xHz component had a real component of average real magnitude R and average imaginary magnitude I). The system of the invention provides, at time T, the xHz sinusoid with magnitude M (and phase P) where xHz is the output of the filter at frequency xHz, where x is any value up to the Nyquist frequency. By having more than one filter's output stream and comparing the output to other filters outputs running in parallel it is possible to determine the sinusoidal/non sinusoidal nature of one or more components of the signal.

The data extracted comprises local peaks in the output of the filters, each local peak being a local peak in both of the time and frequency directions. The peak identified is an amplitude peak in the output of a filter which is greater than the amplitude of the peaks of adjacent filters. If the output of the filters is rendered as a three-dimensional topology, the identified peaks are the tops of hills in this topology. During the processing of the signal, following the filtering, data is extracted from the output of the filters. The output of each filter is a signal of varying amplitude at a specific frequency (the centre frequency of the filter). How the data is extracted depends upon the ultimate purpose of the signal processing (whether for compression, or analysis etc.).

In the prior art document GB 2034056, no local peaks in the output of the filters are identified, the apparatus operates so that the current energy levels of each filter are simply displayed. In the system of the present invention, local peaks in the output of the filters are identified. For example, if the values returned by a filter f₁ are 92, 94, 92, 94, 96 and 94, then two local peaks are present in this series of values, the first "94" and the "96", but these are local peaks in the time direction only. The system of the present invention identifies those peaks that are local peaks in both of the time and frequency directions. This means that any value that is a local peak in the time direction must also be greater than the returned peak values for each adjacent filter to filter f₁, if they are to be a local peak in both dimensions.

Effectively, the outputs of the filters are transposed into a three-dimensional topology, with the axes being time, frequency and amplitude (or energy). The output of each individual filter is a two-dimensional curve, and the output of all the filters together is a three-dimensional surface. In the surface defined by the values returned by the filters, the local peaks in both of the time and frequency domains are represented as the top of hills, and these are the points identified, in the processing of the filter output. The importance of this is that a very complex signal is reduced to a relatively small number of identified peaks, which nevertheless encapsulates the important information contained within the incoming signal.

Advantageously, the band pass filters are a plurality of cascading band pass filters, each cascade of filters having the same centre frequency and a Q of greater than 1/√2. According to the invention adjacent filters (adjacent in the frequency sense) and cascaded filters do not have the same Q value.

Advantageously, the local peaks are detected at the output of each cascade stage. The data to be extracted from amplitude peaks of the curves output by the filters allows recreation of the sine waves that constitute the original signal. Effectively a translation of the signal takes place from a received complex signal through to a series of curves to co-ordinates defining the amplitude and the time of peaks of the surface defined by the curves.

The data extracted from the output of the filters could alternatively (or additionally) be the area under the curve generated by each filter, or could be points on the signal that pass absolute or relative levels in the wave. Turning points in the signal could be the data extracted. The data extraction could be carried out at the topology level with techniques such as ridge finding being used to define features present within the surface defined by output of the filters.

Advantageously, the processing further comprises executing a curve fitting procedure, the output of which procedure comprises curve data defining a curve that at least approximates to a portion of the extracted data. The curve fitting is a further translation of the original signal. In the case where the extracted data is local peaks of the surface, then curve data can be generated that defines a curve that passes through the local peaks (or approximates to those local peaks).

As an example for illustrative purposes, if the processing of the signal uses ten filters, then a signal of varying amplitude over time is the output of each filter, resulting in ten separate signals. These signals viewed together define a surface. The extracted data is the peaks of this surface, and the curve fitting outputs curve data defining separate three-dimensional curves that will each fit peaks in the defined surface.

The curve fitting may link together points that actually originated in different filter outputs, so that the curve defined in the curve fitting travels across the frequency domain. The curve fitting may in fact define a surface that links together multiple points that form part of the extracted data. In order to compensate for the known filter start up and end errors, it would also be advantageous to iterate these curves backwards in time.

The reverse of the data extraction process can be carried out, either with or without intermediate processing (such as error-correction or compression) to recreate a signal that at least approximates to (and may be identical to) the original signal. In order to re-synthesise, sine waves may be generated that last for the duration of the inter-peak distance. For example, if only positive peaks are detected, then the sine wave would last one full cycle. If both positive and negative peaks are detected then the sine wave would last a ½ cycle. The sine waves may be generated by various methods. On a microprocessor this might be achieved by calling a sine function, or by using lookup tables. The sine waves may advantageously be generated by resonators/oscillators such that the error caused by starting/stopping the wave is passed on to the next resonator cycle. If the signal is deemed to be a signal that is varying in frequency the resonator/oscillator may instead be re-tuned to the new frequency. Advantageously, if the curve fitting procedure has been performed on the localised peaks, the frequency of the sine waves may be updated at intervals smaller than the distance between peaks.

In addition, the processing further comprises varying the Q factor of at least one band pass filter as the signal is filtered. This supports better discrimination (zoom in on) of different sinusoids, and/or allows for static threshold level comparators, for example a fixed precision/mechanical system. This, in some situations, will give a processing power advantage.

In addition, the number of band pass filters can be variable, and the method further comprises varying the number of band pass filters as the signal is filtered. A complex signal will have a large number of different components at different frequencies. It is more efficient to adapt the number of filters being used to process the signal to the number of components in the signal. A filter could be set to cover a relatively wide frequency band, and when activity is detected in that band multiple narrower filters can then be used to filter the different components in that band. This process can be continuous and flexible as the signal is processed. This, in some situations, will give a processing power advantage.

In one embodiment, the plurality of band pass filters comprises approximately an integer multiple of three per component of the received signal, and the processing further comprises tracking each component of the received signal using a set of three band pass filters. If a complex received signal has twenty components within it, then sixty filters can be used to track the components. Each component of the signal can be filtered with a narrow filter with a broader filter on either side (in the frequency dimension), giving three filters per component. If the components change frequency, this can be tracked by the set of three filters, with the broader filters on either side of the centre filter detecting the direction of any change. The frequencies at which the filters operate are adjusted automatically and dynamically as the components change frequency. This, in some situations, will give a processing power advantage.

The number of filters used in the processing can be determined on the basis of the number of octaves in which there is activity in the received signal. The plurality of band pass filters could comprise approximately one per frequency octave of the received signal, or for a more detailed interpretation of the signal, the plurality of band pass filters could comprise approximately an integer multiple of twelve per frequency octave of the received signal. As the number of filters used increases, and the frequency spacing between them decreases, the resolution of the system increases.

Preferably, the processing further comprises executing an harmonic relationship determination procedure, the output of which procedure comprises harmonic relationship data identifying harmonic relationships between different identified sine waves. The extracted data may reveal, when examined, that within the received signal there are musical and/or vocal harmonics (in the case of an audio signal). This can be detected automatically and the data on the harmonics can be generated and stored, which reduces the amount of extracted data that is needed, for example when recreating the original signal.

The process may further comprise varying the gain of one or more filters, as the signal is filtered. The main advantage of this is to allow for static threshold level comparators, for example a fixed precision/mechanical comparator system.

In one embodiment of the system, the processing further comprises displaying a representation of the extracted data. This representation could be a view of a three-dimensional surface of the data, with time on the x axis, frequency on the y axis and amplitude on the z axis.

For the avoidance of doubt the present invention may be implemented in a dedicated device in standalone form (either hand-held or free-standing) or comprised within a larger device or host device/system comprising other functionality, for example a mobile communications device, PDA, personal computer, laptop, game console or vending machine etc. Such apparatus, system or devices may comprise a single integrated circuit or alternatively the different functionalities may be provided by or implemented in separate component parts of separate integrated circuits.

It will be understood by persons skilled in the art that many other systems, devices and methods can be advantageously designed incorporating the present invention.

Many embodiments of aspects of the invention described herein are shown and described with reference to electronic components, circuits and/or block diagrams and persons skilled in the art will know that algorithms or software operating under the control of processors may advantageously simulate such components, circuits and/or block diagrams, where the processors, algorithms and/or software form part of the embodiments. It will be understood by persons skilled in the art that one or more of electronic components, circuits and/or block diagrams forming any part of any aspect of any embodiment of the invention may be advantageously formed from any combination of discrete, integrated or simulated components. Integrated components may comprise for example components fabricated with integrated circuit processes and/or micromachined processes. One advantage of the use of simulated components is to provide control of highly accurate component values whether the values are fixed or are required to be variable. Other advantages of the use of simulated components are that adjacent filters do not interact with each other, and that the filter outputs are mathematically ideal (apart from rounding errors). This does not however preclude embodiments that are not simulated as high tolerance components might become available in the future.

Where any component is simulated and/or where any processing is carried out in the digital domain, persons skilled in the art will know that prior to such processing, signals must be provided in digital form or one or more analogue to digital converters (not shown in any of the accompanying figures) will be used to generate digitized or sampled forms of signals. The rate of such sampling is dependent on the highest frequencies of the signals being analysed.

Many embodiments of aspects of the invention described herein are shown and described with reference to band pass filters (BPF) and/or notch filters (NF) and persons skilled in the art will know that where such filters are shown and/or described, the filters may advantageously comprise any combination of higher order filters, low pass filters (LPF), high pass filters (HPF), and/or active components such as amplifiers. Band pass filters in preferred embodiments will comprise infinite impulse response filters (IIR). Some embodiments may advantageously comprise an alternative method of providing the BPF output data which is fed to the inputs of events generators or other data reduction stages, where such alternative events generator input data may comprise for example data from exponential windowing function followed by a fast fourier transform (FFT) process, where the input signal is fed to the input of such exponential windowing function and where benefits may include faster data computational speed.

The functions of any one or more component, circuit, and/or block diagram may be carried out in any combination of sequential, serial and/or parallel operations by one or more processors. Such processors may comprise digital signal processors, parallel processors, state machines, microprocessors, microcontrollers, personal computers, mainframe computers or the like.

Persons skilled in the art will know that signals that require analysis and which may be analysed by the present invention, may be provided from any source and examples of such sources include signals previously captured or generated and stored in analogue or digital form, and signals received in real-time from sensors, transducers and/or from scenario simulations. Specific examples of such signal sources include: hydrophones, microphones, communications or broadcast radio receivers, TV or video equipment, radar equipment, radio telescopes, medical imaging equipment (such as MRI, CAT, IR, ultrasound and X-ray), intelligent systems medical analysis, medical or scientific simulation equipment.

Further features and advantages of the invention will become apparent from the following description of preferred embodiments of the invention, given by way of examples only, which are made with reference to the accompanying drawings.
Figure 1 is a flow diagram describing a first signal analyser;
Figure 2 is a flow diagram describing a second signal analyser;
Figure 3 is a flow diagram describing a third signal analyser;
Figure 4 is a flow diagram describing a fourth signal analyser;
Figure 5 shows a preferred embodiment of apparatus according to an aspect of the invention;
Figure 6 shows an example embodiment apparatus according to an aspect of the invention;
Figure 7 shows an example signal comprising a single sinusoid of varying amplitude and example events occurring at signal peaks;
Figure 8 shows an example events stream;
Figure 9 shows example filter responses;
Figure 10 shows an example events stream and example curves joining the tops of the events;
Figure 11 shows an example apparatus providing BPF quality factor (Q) and/or centre frequency feedback control;
Figure 12 shows example harmonic series that may be identified by a harmonic relationship determination stage;
Figure 13 shows an example first alternative data reduction method which may be used to generate events;
Figure 14 shows an example second alternative data reduction method which may be used to generate events;
Figure 15 shows an example three-dimensional curve;
Figure 16 shows a three-dimensional surface corresponding to the output of multiple band pass filters;
Figure 17 shows the result of a data extraction performed on the surface of Figure 16;
Figures 18 and 19 show the input, output and peak detect of two different 6^{th} order bandpass filters;
Figure 20 shows a diagram of a signal and the output of data extraction on that signal;
Figure 21 shows a sinusoidal reconstruction of the signal of Figure 20, and
Figure 22 shows a diagram similar to Figure 20 of a signal and the output of data extraction on that signal.

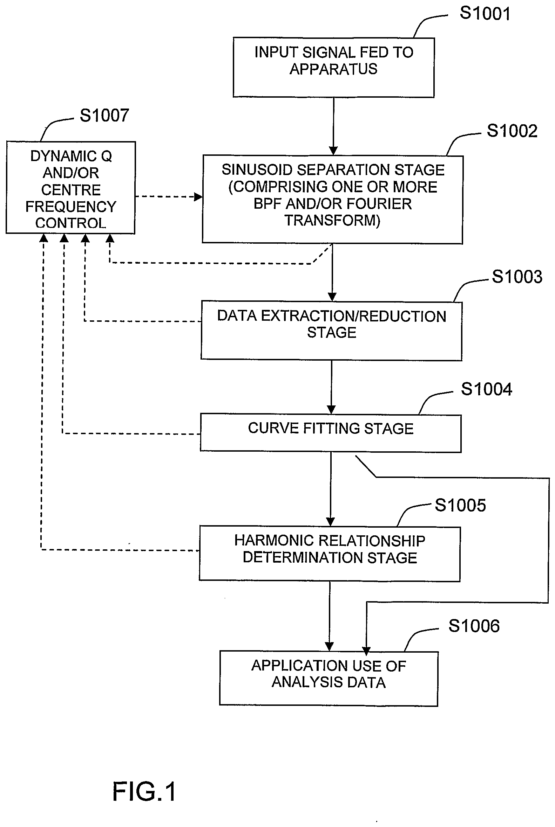

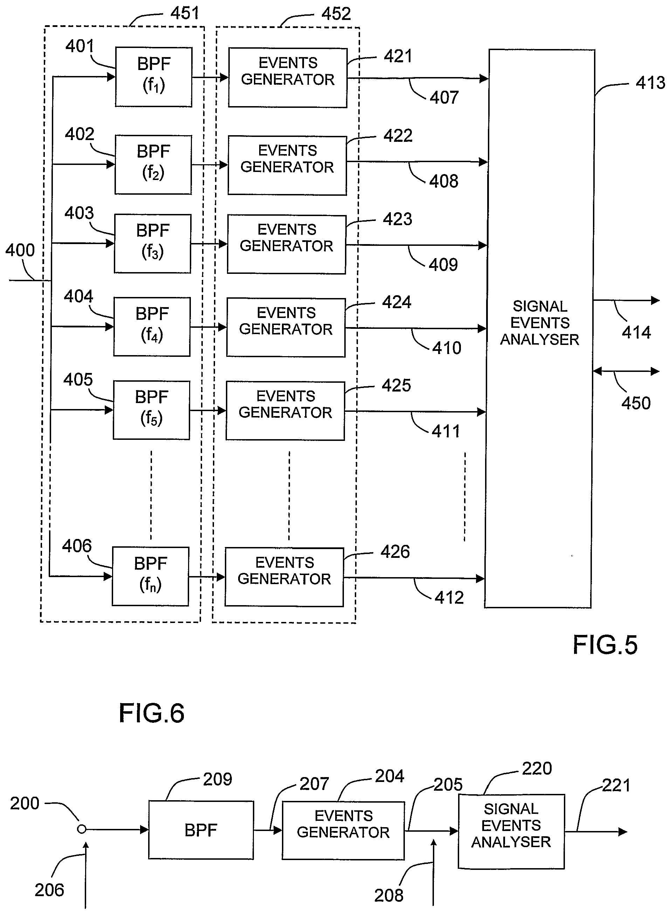

A variety of different signal processing methods are shown in Figures 1 to 4. An example of the system and apparatus for carrying out any of these methods is shown in Figure 5. In general, the apparatus for processing the signal comprises a receiver for receiving a signal, one or more filters for filtering the signal and a processor for carrying our processes such as data extraction/reduction. The processor may advantageously dynamically control the operation of the filters.

Apparatus according to aspects of the invention comprise combinations of one or more processing stages. The processing stages include a sinusoid separation stage, a data extraction/reduction stage, a curve fitting stage, a harmonic relationship determination stage, a data processing and manipulation stage, and/or an inverse transform stage.

The sinusoid separation stage can comprise one or more of BPF and/or Fourier transform. Such a sinusoid separation stage may output amplitude, frequency, time and/or Q information relating to the input signal. Persons skilled in the art will recognise the use of the upper-case character Q to designate the characteristic known as quality factor in filter or tuned circuits.

A data extraction/reduction stage is used to extract data from the separated sinusoids, such as amplitude peaks of the sine waves, or the area defined by the waves. Data reduction is to reduce the amount of data output from the sinusoid separation stage where such data reduction is appropriate for particular applications in order to maximise data reduction while retaining sufficient information for a particular application.

A first embodiment of the signal analyser is described with reference to the flow diagram of Figure 1. The flow diagram shows how the apparatus transforms an input signal. An input signal is fed to the apparatus at step S1001. At step S1002 a sinusoid separation stage which comprises one or more BPF and/or Fourier transform, the apparatus determines information relating to sinusoids in the input signal and outputs information which may include amplitude, frequency, time and/or Q information relating to the input signal.

All such information is fed to step S1003 a data extraction/reduction stage (example data reduction methods are described in more detail below). In the simplest form of the signal analysis method, no data reduction takes place. At this stage S1003, the data extraction from the output of the filters comprises identifying local peaks in the output of the filters, each local peak being a local peak in both the time and frequency directions. How this data (the local peaks) is then handled depends upon the application in which the signal analysis method is being used.

Other data can be extracted from the output of the filters. For example, this data could be the area under the curve defined by each filter, between two zero-crossing points. Before extraction takes place, the output of each filter could be processed, for example to determine if the curve of a filter output is sinusoidal. Only those curves that are sinusoidal could then be used in the data extraction stage.

In the embodiment of Figure 1, data output from step S1003 is fed to step S1004. At step S1004, a curve fitting stage, the apparatus determines the nature of lines formed by joining local peaks, each local peak being a local peak in both the time and frequency directions. Such determination of the nature of said lines may include the determination of coefficients that describe the curvature and/or shape-nature of portions of or complete lines. Information output from step S1004 is fed to one or both of step S1005 and step S1006.

The apparatus may include at step S1005 a harmonic relationship determination stage, where information relating to separated sinusoids within the input signal is used to identify the presence of one or more harmonic series. Each harmonic series may comprise one or more of fundamental, second harmonic, third harmonic, fourth harmonic, fifth harmonic and any other harmonics for example. Output from step S1005, if present, is fed to step S1006.

At step S1006 information determined at step S1004 and/or step S1005 is used by the apparatus according to requirements of particular applications. Such information use includes for example storage, further processing, further analysis, signal reconstruction, and/or outputting to for example visual display devices and/or audio output device and or any transducer/actuator. The apparatus may include dynamic Q control if the sinusoid separation stage comprises one or more BPF with an associated quality factor (Q) characteristic. The apparatus may include dynamic centre frequency control of one or more BPF.

Such dynamic Q and/or dynamic centre frequency control is represented as step S1007 which may take input data from one or more of steps S1002 to S1005, and where the output of step S1007 is fed to step S1002 where output information from step S1007 is used to control the Q and/or the centre frequency of one or more BPF within the sinusoid separation stage (Such dynamic Q and centre frequency control is described in more detail later).

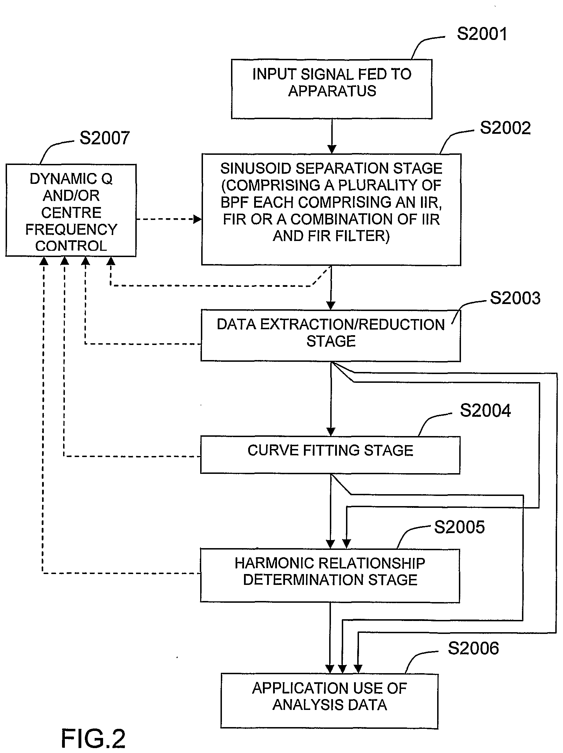

A second embodiment of the signal analyser is described with reference to the flow diagram of Figure 2. An input signal is fed to the apparatus at step S2001. At step S2002 a sinusoid separation stage which comprises a plurality of BPF, the apparatus determines information relating to sinusoids in the input signal and outputs information which may include amplitude, frequency, time and/or Q information relating to the input signal.

At step S2002 each BPF comprises an IIR filter, or a finite impulse response (FIR) filter or a combination of IIR and FIR filter. Such FIR filters may comprise an IIR impulse response which may be achieved by the use of an exponential windowing function followed by an FFT. All such information from step S2002 is fed to step S2003 a data reduction stage (example data reduction methods are described in more detail below). Data output from step S2003 is fed to one or more of steps S2004, S2005, or S2006.

The apparatus may include at step S2004 a curve fitting stage, the apparatus determines the nature of lines formed by joining local peaks, each local peak being a local peak in both the time and frequency directions. Such determination of the nature of said lines may include the determination of coefficients that describe the curvature and/or shape-nature of portions of or complete lines. Information output from step S2004, if present, is fed to one or both of step S2005 and step S2006.

The apparatus may also include at step S2005 a harmonic relationship determination stage, where information relating to separated sinusoids within the input signal is used to identify the presence of one or more harmonic series. Each harmonic series may comprise one or more of fundamental, second harmonic, third harmonic, fourth harmonic, fifth harmonic and any other harmonics for example. Output from step S2005, if present, is fed to step S2006.

At step S2006 information determined at step S2003 and/or step S2004 and/or step S2005 is used by the apparatus according to requirements of particular applications. Such information use includes for example storage, further processing, further analysis, signal reconstruction, and/or outputting to for example visual display devices and/or audio output devices and or any transducer/actuator.

The apparatus may include dynamic Q control if the sinusoid separation stage comprises one or more BPF with an associated quality factor (Q) characteristic. The apparatus may include dynamic centre frequency control of one or more BPF. Such dynamic Q and/or dynamic centre frequency control is represented as step S2007 which may take input data from one or more of steps S2002 to S2005, and where the output of step S2007 is fed to step S2002 where output information from step S2007 is used to control the Q and/or the centre frequency of one or more BPF within the sinusoid separation stage (Such dynamic Q and centre frequency control is described in more detail later).

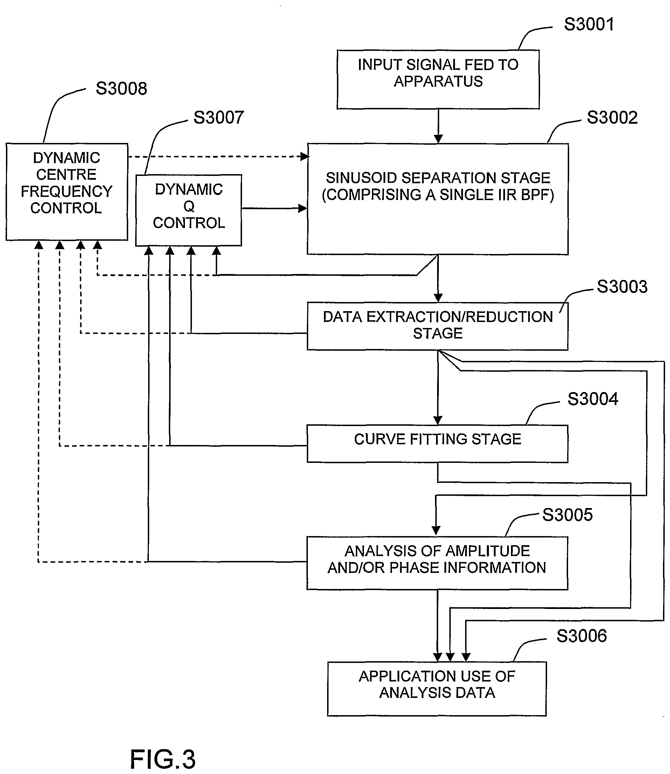

A third embodiment of the signal analyser is described with reference to the flow diagram of Figure 3. An input signal is fed to the apparatus at step S3001. At step S3002 a sinusoid separation stage which comprises a single IIR BPF, the apparatus determines information relating to sinusoids in the input signal and outputs information which may include amplitude, frequency, time and Q information relating to the input signal. All such information from step S3002 is fed to step S3003 a data reduction stage (example data reduction methods are described in more detail below).

Data output from step S3003 is fed to one or more of steps S3004, S3005, or S3006. The apparatus may include at step S3004 a curve fitting stage, the apparatus determines the nature of lines formed by joining local peaks, each local peak being a local peak in both the time and frequency directions. Such determination of the nature of said lines may include the determination of coefficients that describe the curvature and/or shape-nature of portions of or complete lines. Information output from step S3004, if present, is fed to step S3006.

The apparatus may also include at step S3005 a processing stage that carries out analysis of amplitude and/or phase information. Output from step S3005, if present, is fed to step S3006. At step S3006 information determined at step S3003 and/or step S3004 and/or step S3005 is used by the apparatus according to requirements of particular applications. Such information use includes for example storage, further processing, further analysis, signal reconstruction, and/or outputting to for example visual display devices and/or audio output device and or any transducer or actuator device.

The apparatus may include dynamic Q control. Such dynamic Q control is represented as step S3007 which may take input data from one or more of steps S3002 to S3005, and where the output of step S3007 is fed to step. S3002 where output information from step S3007 is used to control the Q of the BPF within the sinusoid separation stage.

The apparatus may include dynamic centre frequency control of one or more BPF. Such dynamic centre frequency control is represented as step S3008 which may take input data from one or more of steps S3002 to S3005, and where the output of step S3008 is fed to step S3002 where output information from step S3008 is used to control the centre frequency of the BPF within the sinusoid separation stage (Such dynamic centre frequency control is described in more detail later).

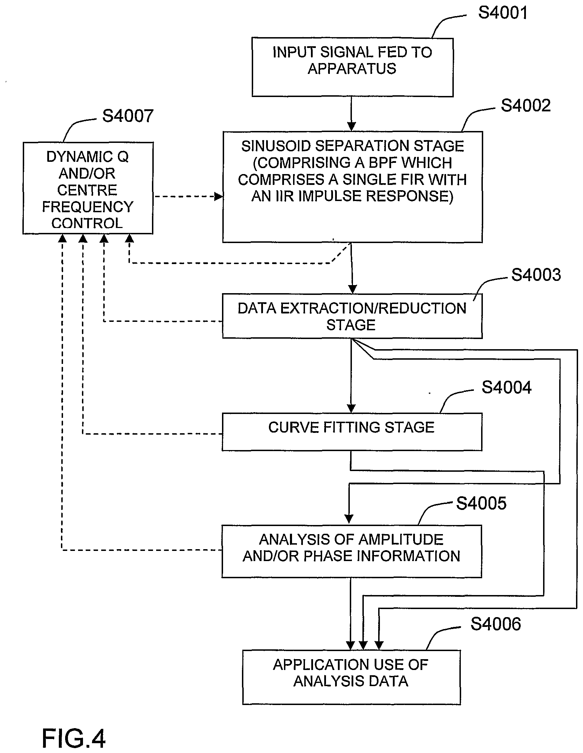

A fourth embodiment of the signal analyser is described with reference to the flow diagram of Figure 4. An input signal is fed to the apparatus at step S4001. At step S4002 a sinusoid separation stage which comprises a single BPF, the apparatus determines information relating to sinusoids in the input signal and outputs information which may include amplitude, frequency, time and/or Q information relating to the input signal.

At step S4002 the BPF comprises a finite impulse response (FIR) filter with an IIR impulse response (which may be achieved by the use of an exponential windowing function followed by an FFT). All such information from step S4002 is fed to step S4003 a data reduction stage (example data reduction methods are described in more detail below).

Data output from step S4003 is fed to one or more of steps S4004, S4005, or S4006. The apparatus may optionally include at step S4004 a curve fitting stage, the apparatus determines the nature of lines formed by joining local amplitude peaks each local peak being a local peak in both the time and frequency directions. Such determination of the nature of said lines may include the determination of coefficients that describe the curvature and/or shape-nature of portions of or complete lines.

Information output from step S4004, if present, is fed to step S4006. The apparatus may optionally include at step S4005 a processing stage that carries out analysis of amplitude and/or phase information. Output from step S4005, if present, is fed to step S4006. At step S4006 information determined at step S4003 and/or step S4004 and/or step S4005 is used by the apparatus according to requirements of particular applications. Such information use includes for example storage, further processing, further analysis, signal reconstruction, and/or outputting to for example visual display devices and/or audio device device and or any other transducer or actuator device.

The apparatus may optionally include dynamic Q control. The apparatus may optionally include dynamic centre frequency control of one or more BPF. Such dynamic Q and/or dynamic centre frequency control is represented as step S4007 which may take input data from one or more of steps S4002 to S4005, and where the output of step S4007 is fed to step S4002 where output information from step S4007 is used to control the Q and/or the centre frequency of the BPF within the sinusoid separation stage (Such dynamic Q and centre frequency control is described in more detail later).

Figure 5 shows a preferred embodiment of a system for processing a signal. The system includes a receiver for receiving a signal 400. The system further includes a sinusoid separation stage 451, a data extraction/reduction stage 452, and a signal events analyser 413. The sinusoid separation stage 451 comprises a plurality of band pass filters (BPF). The data reduction stage 452 comprises a plurality of event generators. The signal events analyser 413 can execute one or more of a curve fitting stage, a harmonic relationship determination stage, a data processing and manipulation stage and/or an inverse transform stage. The series of events generators 421 and the signal events analyser 413 can be implemented as a single processor.

The input signal 400 is fed to the input of each of the BPFs (401 - 406) and the output of each BPF is fed to the input of a respective event generator (421 - 426). Higher order band pass filter arrangements can be used, for example 4^{th} order and 6^{th} order filter arrangements can be used with respectively two and three filters connected in series as a cascade. In this case data extraction can be carried out at intermediate stages in the filtering, with extraction carried out the output of the first (and so on) filters and on the final output.

The output of each event generator is fed to an input of a signal events analyser 413. Data output 414 from the signal events analyser provides a description and analysis of the input signal 400 and may comprise curve coefficients and/or information relating to events information. Where such curve coefficients describe curves, each curve is defined as a line moving from one maximum amplitude event to another maximum amplitude event. Communications interface 450 may facilitate control data to be communicated with a larger device or system (not shown).

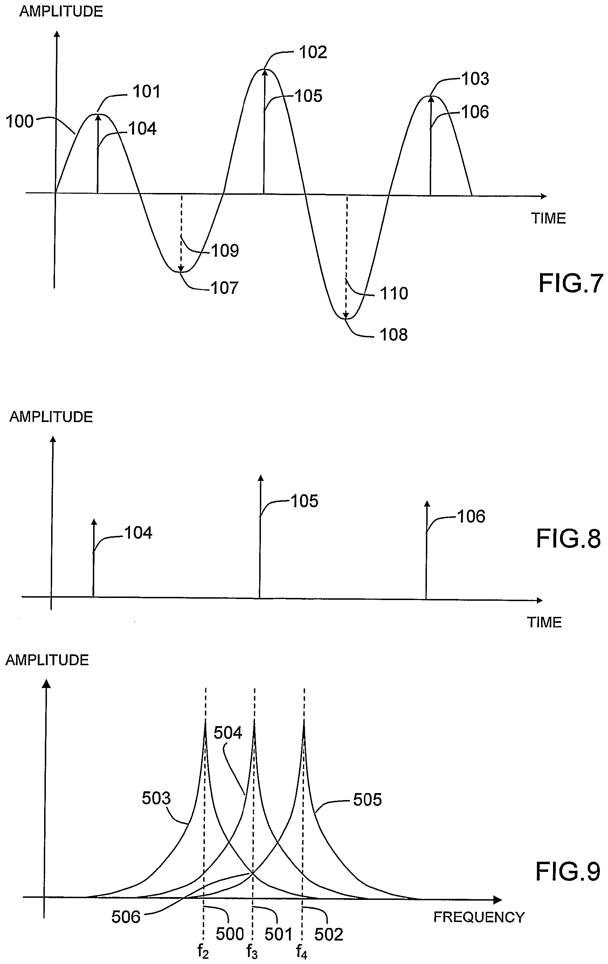

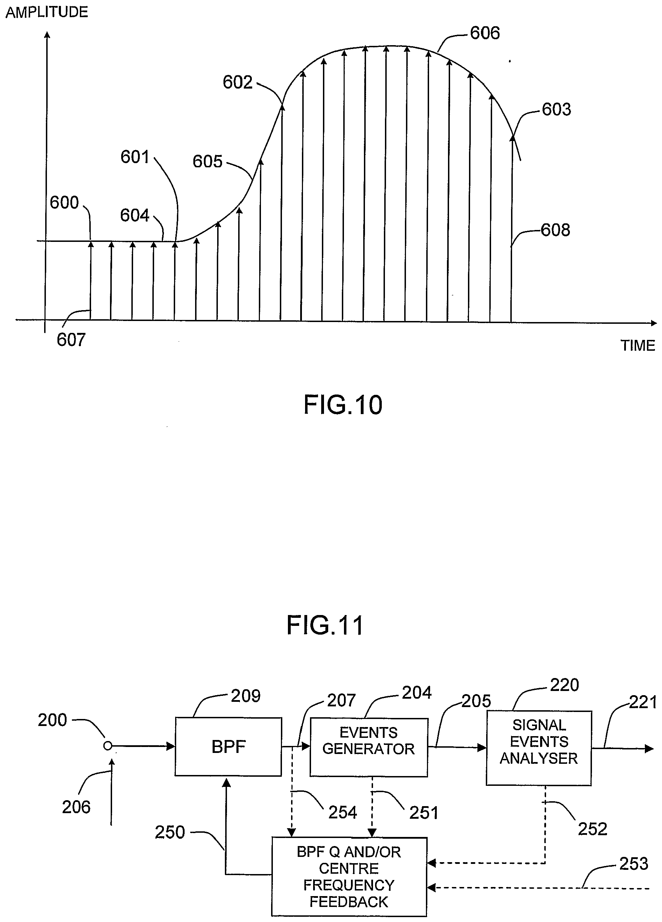

The description of the operation of the apparatus of Figure 5 will now be described with reference to Figure 6 which shows a single BPF, a single event generator and a signal events analyser, with reference to Figure 7 which shows an example signal comprising a single sinusoid of varying amplitude, with reference to Figure 8 which shows an example events stream, with reference to Figure 10 which shows an alternative example events stream and example curves and with reference to Figure 11 which shows how dynamic Q and/or centre frequency control may be used.

Figure 7 shows a signal 100 which is a single sinusoid of varying amplitude. This signal 100 will be the output of one of the BPFs of Figure 5. It has been determined that signal 100 can be precisely represented by an event stream, where each event comprises information relating to a peak in the signal. Such event information comprises two parts where a first part comprises a value which is proportional to the peak amplitude which may be represented for example as energy, current or voltage and where a second part comprises a record of the time that the peak occurred. The events generator 204 carries out data reduction because such event information comprises less data than data output from BPF 209.

Events represented by the arrows 104, 105 and 106 are example events and form part of the event stream of signal 100, and occur respectively at peaks 101, 102 and 103. Alternatively the event stream may comprise negative peak events shown as dotted line arrows 109 and 110 occurring respectively at negative peaks 107 and 108. As a further alternative, the event stream may comprise events relating to both positive and negative peaks.

Figure 6 shows an example embodiment apparatus which comprises BPF 209 which has a Q factor of 1/-√2, event generator 204 and signal events analyser 220. BPF 209 comprises one of the filters 401 - 406 of Figure 5. Event generator 204 comprises one of event generators 421 - 426 of Figure 5. Signal events analyser 220 comprises part or all of signal events analyser 413 of Figure 5.

An input signal 206 is coupled to node 200 which is the input to the band pass filter 209 where the band pass filter comprises an IIR filter. The band pass filter output, signal 207 is fed to the input of event generator 204. The event generator 204 comprises circuitry and/or a processor running an algorithm such that events are generated relating to positive signal peaks as described in Figure 7. The output of event generator 204 in Figure 6 is shown as signal node 205 and provides an event stream 208 continuously during the presence of a signal at node 207. An example portion of such an event stream is shown in Figure 8 as arrows 104, 105 and 106 (where 104, 105 and 106 represent identically labelled events shown in Figure 7). Referring again to Figure 6, the event generator 204 may recognise peaks in a number of ways, in any combination, for example, value change, value differentiation. The value change method may for example function by storing one or more previous amplitude sample values such that when sample values decrease a peak is recognised. The value differentiation method may for example function by comprising circuitry and/or a processor running an algorithm that differentiates the signal 207 such that when the differentiated signal reaches zero, an event is generated.

The input signal 206 may comprise a single sinusoid of frequency at or near to the band pass filter centre frequency or may comprise more than one sinusoid, one of which is at or near to the band pass filter centre frequency.

Events 208 are output at node 205 at the time they occur and are received by the signal events analyser 220. The signal events analyser uses events information and may determine the presence of sinusoids in the input signal, at or near to the band pass filter centre frequency, to a very high temporal resolution; to a single event (or one half cycle). The determination of such fine temporal resolution may require the use of the values of filter Q (quality factor) and/or data relating to filter order and/or data relating to filter characteristics within the signal events analyser such that effects such as response times may be compensated for. The signal events analyser outputs output data 221, relating to the input signal 200.

The signal events analyser 220 may use the event stream information as events occur or alternatively the signal events analyser may store the event information for use at a later time.
- In some embodiments it may be advantageous to include storage means within the event generator 204 and in such a case the event generator would store filter output sample data, node 207, and process subsequently such data to derive events information.

In a preferred embodiment the signal events analyser 220 includes one or more algorithms to determine the curvature of portions of lines where such lines are formed by joining the top of events where such algorithms form a curve fitting stage. An example is shown in Figure 10 where an events stream starting at event 607 and ending at event 608 represents the input signal (200 in Figure 6) during the time shown in Figure 10. The input signal is described by curves 604, 605, and 606. Curve 604, in this case a straight line, starts at event amplitude 600 and ends at event amplitude 601. Curve 605 starts at event amplitude 601 and ends at event amplitude 602. Curve 606 starts at event amplitude 602 and ends at event amplitude 603. The curvature of each line may be defined by three coefficients and the three coefficients are derived from events information.

Persons skilled in the art will know that such derivation of curve coefficients may be obtained with known curve-fitting algorithms for example. In many examples of input signal variations, coefficients from one curve may form one or more coefficients of the following curve. Alternatively in some embodiments it may be beneficial to derive coefficients that describe more complex curves such as for example the whole of the curve in Figure 10 from point 600 to point 603. Describing an input signal with a series of coefficients that represent a series of one or more curves provides a new method of analysing and processing signals.

Referring again to Figure 6, in some embodiments it may be advantageous to include dynamic Q control (shown as steps S1007, S2007, S3007 and S4007 in Figures 1 to 4 respectively, and may be used to control the Q of one or more filters 401 to 406 of Figure 5). Such dynamic Q control provides control of the Q of filter 209 in relation to event amplitudes at node 205 and/or filter output amplitudes at node 207. Such feedback control of filter Q may additionally or alternatively be affected by signals from other sources, such as for example the signal events analyser 220, communicating with node 205. Figure 11 shows example signals 251, 252, 253 and 254 that may be used to control the Q of filter 209 via Q feedback control 250 (items labelled 200, 204, 205, 206, 207, 209, 220 and 221 have the same function as the identically labelled items in Figure 6).

Where filter Q is controlled to increase in relation to increases in signal amplitudes at node 207 and/or node 205, control of limitation of signal amplitude at node 207 and/or 205 may be required to avoid oscillation/instability, and such limitation may be achieved for example by any combination of additional control loop of the feedback signal, slew-rate control of the feedback signal, control of gain/attenuation within event generator 204, and/or a feedback signal being dependant upon a measure of energy and/or signal level in one or more preceding samples.

In some embodiments it may be advantageous to control the gain/attenuation within event generator 204 in relation to event amplitudes at node 205 and/or filter output amplitudes at node 207.

Embodiments may include filter Q feedback control in order to increase input signal frequency discrimination. Such discrimination will occur because input signals of a frequency different to the filter centre frequency will be attenuated more as filter Q increases (the filter response, for example 503 in Figure 9, will become narrower), whereas input signals of a frequency equal to that of the filter centre frequency will be attenuated less (the filter response curve will increase in amplitude at the centre frequency as it becomes narrower).

Embodiments may include filter Q and/or gain/attenuation feedback control in order to reduce the amount of data processing in event generator 204 and/or signal events analyser 220, such that for example data values are kept within a predetermined range to enable processing to be carried out using integer arithmetic.

Embodiments may include filter Q and/or gain/attenuation feedback control in order to increase response time of filter 209. Such response time may be increased if for example filter Q starts at a low level and increases as a signal is detected.

Referring again to Figure 6, in some embodiments it may be advantageous to include dynamic centre frequency control (shown as steps S1007, S2007, S3008 and S4007 in Figures 1 to 4 respectively, and may be used to control the centre frequency of one or more filters 401 to 406 of Figure 5). Such dynamic centre frequency control provides control of the centre frequency of filter 209 in relation to event amplitudes at node 205 and/or filter output amplitudes at node 207. Such feedback control of filter centre frequency may additionally or alternatively be affected by signals from other sources, such as for example the signal events analyser 220, communicating with node 205. Figure 11 shows example signals 251, 252, 253 and 254 that may be used to control the centre frequency of filter 209 via centre frequency feedback control 250 (items labelled 200, 204, 205, 206, 207, 209, 220 and 221 have the same function as the identically labelled items in Figure 6).

Embodiments may include filter centre frequency feedback control in order to for example lock onto or track an input signal where the frequency of the input signal is close to but not equal to the current BPF centre frequency.

Applications for the apparatus of Figure 6 and/or Figure 11 include those that require very rapid detection of the presence of a signal and/or require the rapid detection of a change to a signal. One example is amplitude demodulation where the rapid modulation changes need to be distinguished between slower amplitude variations due to overall signal strength variations.

A second example is phase demodulation, where modulation edges comprise instantaneous phase inversions, in such signals an event stream occurring at the known frequency will suddenly shift temporally by one half-cycle, and this time shift will be detected on the first or second shifted event. A third example is the detection of small bursts of subcarrier modulation where such bursts may comprise a few cycles of subcarrier for example four cycles. A fourth example is where rapid stabilisation of a phase locked loop is required.

Referring again to Figure 5 the input signal 400 (that is required to be analysed) may comprise at least one sinusoidal signal where any of the at least one sinusoidal signals may fall within a range of frequencies. Any variations described herein for Figure 6 may be included in the apparatus of Figure 5.

The centre frequency of the filter in each BPF 401 - 406 is increased from one BPF to the next BPF, and in this manner the frequency range to be analysed is covered. The centre frequencies and filter bandwidths of each BPF may be such that response curves of nearby BPFs do not overlap and an example of this is shown in Figure 9 where filter responses 503 - 505 with centre frequencies 500 - 502 respectively, correspond to BPFs 402 - 404 (Figure 5). For clarity only three filter response curves are shown in Figure 9.

Referring again to Figure 5, each events generator outputs an event stream and the event streams 407 - 412 from events generators 421 - 426 respectively, are input to the signal events analyser 413.

Six BPFs are shown in Figure 5, however any number may be advantageously included (together with means to derive events from each filter) in a particular apparatus dependant upon the known nature of the input signals required to be analysed by the particular apparatus. For example applications may benefit from the inclusion of two, tens, hundreds, or thousands of BPFs and for example in the field of audio analysis, it may be beneficial to include more than 300 BPFs per octave and to have the centre frequencies increase in a logarithmic manner. Other applications may require BPFs where the centre frequencies increase in a linear manner or in an alternative non-linear manner.

The signal events analyser 413 may communicate via output data 414 and interface 450 with part of a larger system (not shown) where such larger system may comprise for example one or more of memory, additional processors, input interfaces, output interfaces, displays, actuators, wired or wireless communications apparatus.

The output of the data reduction stage 452, comprises the event streams, which describe the input signal, such that the analysis could be used to reconstruct or synthesize the original signal. The signal events analyser may output information giving a representation of each sinusoid present in the input signal. The use of multiple event streams facilitates the analysis of frequency components of an input signal to a very high temporal resolution to a single event.

The signal events analyser may process the event information from any events from event streams from the at least one events generators in such a manner that the input signal 400 is analysed and/or processed according to the signal analysis requirement of a particular apparatus, where such analysis and/or processing may be according to known or expected characteristics of the input signal 400. Such characteristics will vary from one signal type to another and the following signal types are described by way of example only (in the following examples let the centre frequencies of BPFs 401 - 405 be f₁ - f₅ respectively).

In a first example, if the input signal 400 comprises a single sinusoid at frequency f₃ then events generator 423 will output events at frequency f₃. Events generators 422 and 424 will also output events at frequency f₃ (but at a lower amplitude) because, referring to Figure 9, the response curves 503 and 505 show that frequency f₃ 501 is within the pass-bands 503 and 505 shown at point 506. The signal events analyser 413 will determine the events rate from each event stream (from each events generator) and because the signal events analyser will know the centre frequency of each BPF related to each, events generator, the signal events analyser will determine that the events rate from events generators 422 and 424 will be different from the corresponding centre frequencies of BPFs 402 and 404.

The signal events analyser can use all of the events rates and amplitude information to provide an analysis of the input signal. Such analysis may include discarding of events stream information where the events rate differs from the filtered events generator centre frequency, and/or use this difference information along with the reduced amplitude information. In this example the event stream 409 for f₃ describes or provides an analysis of the input signal.

In a second example input signal, if the input signal 400 comprises two sinusoids at frequencies f₂ and f₄ of approximately equal amplitude, then events generator 422 will output events at frequency f₂ however the amplitude of the events will vary according to the relationship between the frequencies f₂ and f₄ (this amplitude variation will relate to the beat frequency of two nearby frequencies). Events from events generator 423 may be used in addition as part of the analysis process.

In a third example input signal, if the input signal 400 comprises an impulse, a peak output level will occur at all event streams and the event stream amplitudes will decay at the same rate per cycle.

Some applications may benefit from added intelligence within each events generator, for example such that where events rates differ from the rate corresponding to the filter, then those events are suppressed or discarded and therefore will not be output to the signal events analyser.

Where one or more processor simulates BPFs and/or events generators then it may be advantageous to reduce the amount of processing by for example reducing the sample rate for groups of BPFs (an anti-aliasing filter will be required before each such group).

Where one or more processor simulates BPFs and/or events generators then it may be advantageous to reduce the amount of processing by for example only carrying out processing for a group of BPFs and events generators when sinusoids are detected by a pre-filter (where the pre-filter bandwidth covers the frequency range of the whole group of BPFs).

In some embodiments signal analysis may be improved by representing signal/events information as a three-dimensional (3-D) map or landscape. People skilled in the art will recognise that a 3-D graph is often represented or described in relation to a conventional 2-D x/y graph with the additional dimension, z, represented as height extending from the 2-D x/y surface. An example of such a 3-D map of event information is where the x-axis represents time, the y-axis represents frequency and the z-axis represents amplitude. The event information may be derived from at least two event generators or from data derived directly from at least two filters. All events may be plotted or a subset of the total events data may be plotted, for example events with a predetermined amplitude relationship to neighbouring events.

One example is where the input signal comprises a single sinusoid of constant frequency and amplitude. In this example the 3-D map would comprise a horizontal straight line in the x-direction at constant amplitude in the z-direction.

Such 3-D mapping may be further processed for analysis purposes or may be displayed and/or printed for example for visual analysis.

In preferred embodiments additional signal analysis and/or signal data compression may be achieved by using event information from at least one event stream as input data to curve-fitting means. Such curve-fitting is described herein with reference to Figure 10 in two dimensions where the dimensions are amplitude and time, however such curve-fitting may be advantageously extended to three dimensions (adding frequency as the third dimension) and in such cases each three-dimensional curve may be formed by joining amplitude values of peak events (where a peak event is an event value higher than its neighbours) where the peak amplitudes may be from nearby or adjacent event streams. Such lines may move through three-dimensional space (described herein as 3-D mapping).

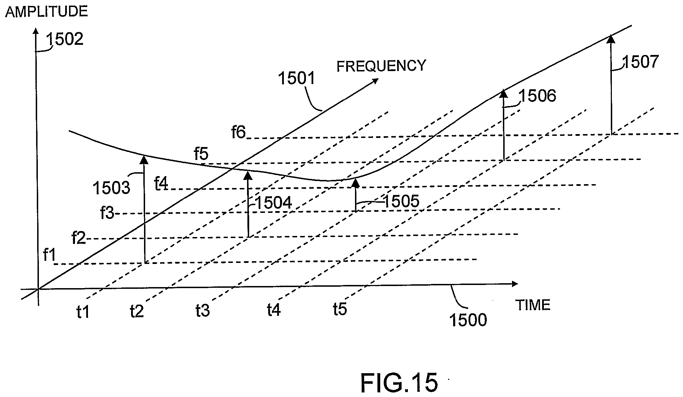

An input signal may comprise one or more of such 3-D lines. Figure 15 shows an example of one such 3-D line forming a curve joining the tops of events 1503 to 1507 (the figure is a two-dimensional representation of three-dimensions where the three dimensions are time, amplitude and frequency and are represented by axes 1500, 1502 and 1503 respectively and are actually orthogonal to each other). The first event 1503 occurs at time t1 and frequency f1, the second event 1504 is of a lower amplitude (t2, f2), the third event 1505 is a lower amplitude again (t3, f4), the fourth event is of an amplitude higher than the third event, and the fifth event 1507 (t5, f6) is of a higher amplitude again. For clarity events from event streams that are not used to form the curve are not shown.

Such curve-fitting may provide one or more sets of curve coefficients that describe the behaviour of the input signal over time. Such curve coefficients may provide a data compressed representation of the input signal.

An example of such curve-fitting is where an input signal comprises a sinusoid at one frequency, which then changes such that the frequency increases over time and the amplitude decreases over time. In this example the 3-D line would comprise a horizontal straight line in the x-direction at constant amplitude in the z-direction until the input signal changes frequency and amplitude. When the input signal changes, the line will move diagonally up in frequency (y-axis) and down in amplitude (z-axis).

In general curve fitting may be carried out in one, two, three or more dimensions. A multidimensional example comprises apparatus comprising a plurality of apparatus of Figure 5 each apparatus of Figure 5 having a separate input signal, where the plurality of apparatus of Figure 5 forms an array and where the separate input signals are derived from a plurality or array of sensors. Such separate input signals may be formed or described as a vector or array. Examples of arrays of such sensors include a video camera sensor, an eye (or simulations of an eye), multi-channel audio recording (including binaural), simulations of stereo hearing. Data from various processing stages within any of the plurality of apparatus of Figure 5 may be combined, processed and/or compared to form output data. Such output data may be used for, but not limited to, any use or application described herein. Additionally, data from any of the various processing stages within any of the apparatus of Figure 5 may be fed into the inputs of any processing stages of any other apparatus of Figure 5. Persons skilled in the art will recognise that there may be other applications that can benefit from alternative multidimensional embodiments of apparatus of the present invention.

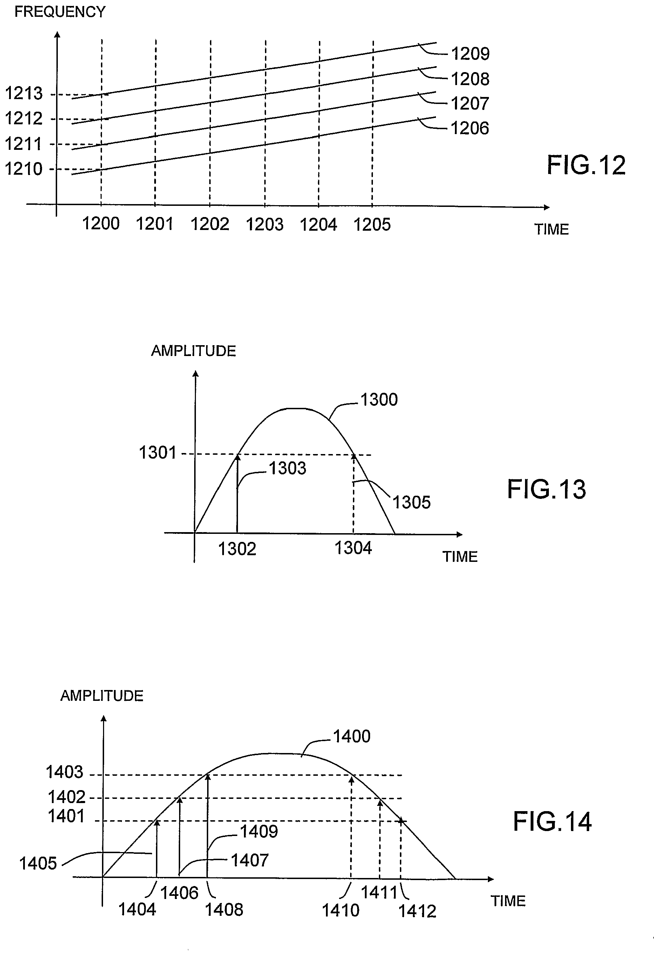

A harmonic relationship determination stage may comprise an algorithm where information relating to separated sinusoids within the input signal is used to identify the presence of one or more harmonic series. Each harmonic series may comprise one or more of fundamental, second harmonic, third harmonic, fourth harmonic, fifth harmonic and any other harmonics for example. With reference to Figure 12, such identification may occur at any particular time, for example at time 1200, where the example harmonic series comprises a fundamental 1206 at frequency 1210, a second harmonic 1207 at frequency 1211, a third harmonic 1208 at frequency 1212 and a fourth harmonic 1209 at frequency 1213 (higher harmonics are not shown for clarity). Similar harmonic series identification may occur at subsequent times (for example at times 1201 to 1204), and in such cases such subsequent identifications may indicate for example a vocal utterance rising in pitch.

There are many applications of harmonic relationship determination signal analysis, and examples include: voice recognition, biometric analysis, musical instrument identification, chemical series recognition, data compression, noise reduction.

In some embodiments it may be advantageous to include an additional data processing and manipulation stage, where input data to such an additional stage is derived from one or more of data reduction stage, curve fitting stage, harmonic relationship determination stage (from any such stages from any combinations of any embodiments described herein). Such an additional processing stage may be required for particular applications and for example may be used to provide information to an inverse transform stage. Such an inverse transform stage may take the form of a parallel synthesiser creating sinusoids and adding them together to form an output signal (such an output signal will comprise amplitude, frequency and phase information). Example applications using a data processing and manipulation stage and an inverse transform stage include shifting the pitch of a musical instrument, shifting the pitch of a vocal utterance, shifting the pitch of a whole signal range, noise cancellation, room acoustic compensation (by analysing a room's frequency response and then subsequently altering amplitudes of particular frequencies in played audio to compensate).

In some embodiments it may be advantageous to use an alternative data reduction stage to generate events. Example alternatives include single fixed threshold and multiple fixed thresholds.

The single fixed threshold alternative data reduction stage is described with reference to Figure 13 and provides yes/no presence information of a sinusoid related to the associated filter frequency. An event 1303 is generated at time 1302 when example sinusoid signal 1300 rises past the threshold 1301. Events so generated indicate the presence of signal 1300. Some applications may benefit from the generation of events when a signal falls below the threshold, and an example of such an event is shown by dotted arrow 1305.

The multiple fixed thresholds alternative data reduction stage is described with reference to Figure 14. The multiple fixed thresholds method functions in a similar manner to the single fixed threshold method, but uses two or more threshold triggering circuits. Three example thresholds are shown as 1401, 1402 and 1403 which result in the generation of events 1405 (at time 1404), 1407 (at time 1406) and 1409 (at time 1408) respectively. Events generated with respect to particular thresholds may comprise information relating to the threshold and/or the time that the event occurred. With the multiple fixed thresholds method, as more levels are used, events become closer together and less data reduction occurs, such that in the limit, levels are effectively continuous and no data reduction occurs.

Persons skilled in the art will know that it may be advantageous to include hysteresis in threshold triggering.

Active or dynamically varying thresholds may be used with either single or multiple threshold methods. Such dynamic threshold variation may be achieved by dynamically varying one or more of the signal inputs to the threshold trigger circuit and/or by varying the Q of the associated filter. Example inputs to the threshold trigger circuit include signal amplitude and threshold amplitude level. Such dynamically varying of a single threshold may be used as an alternative method to derive events for embodiments described herein with reference to Figures 5 to 9 for example.

In some embodiments, whichever data reduction stage is used, it may be advantageous to mask events for given time periods. An example event masking process is where an event triggers a mask time counter such that subsequent events occurring during the mask time period do not reach subsequent processing stages (a mask time period may be an integer multiple of the related BPF period time, for example).

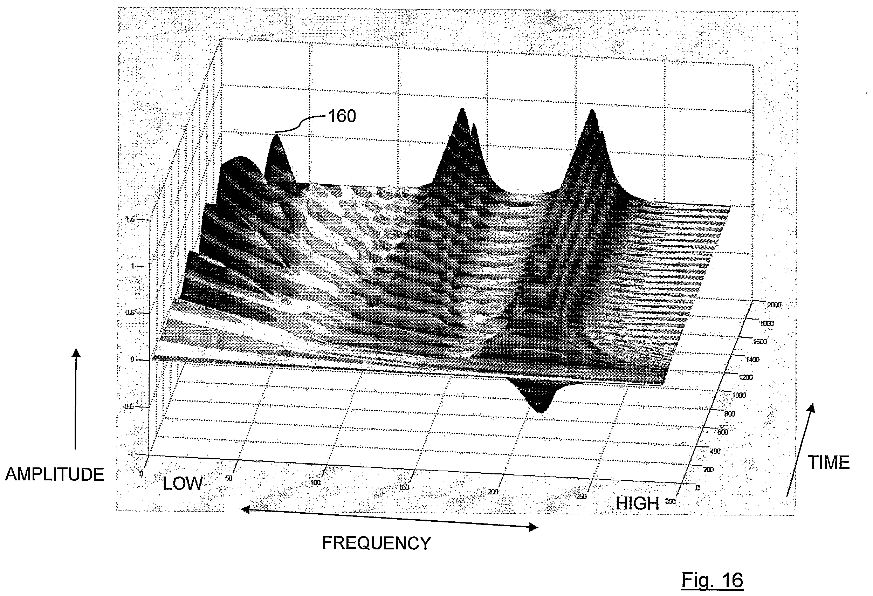

Figure 16 shows a three-dimensional surface. This surface corresponds to the outputs of five hundred and seventy six band pass filters over a time duration 0 to 2000. Each filter is a sixth order filter, meaning that three filters are connected in series as a cascade for each of the five hundred and seventy six different frequencies used. The topology of the surface corresponds to the outputs of the final filter in each cascade. Each final filter has an output that is a curve, and this is used to generate the surface. The input signal that was used to generate this surface comprised three sine waves at different frequencies. It will be appreciated that in many applications, the input signal will comprise a very large number of different sine waves at various frequencies. Nevertheless, a surface will be generated, no matter what the input signal contains.

The principle step in the method of processing the input signal is the data extraction. This data extraction comprises identifying local peaks in the output of the filters, each local peak being a local peak in both the time and frequency directions. As can be appreciated from the visualisation of the topology in Figure 16, a very large number of filters have their own local peaks, but the analysis of the surface of Figure 16 is concerned with identifying peaks that are local peaks in both the frequency and the time direction. One such peak is labelled 160, but multiple dual-direction local peaks are present in the surface shown in Figure 16.

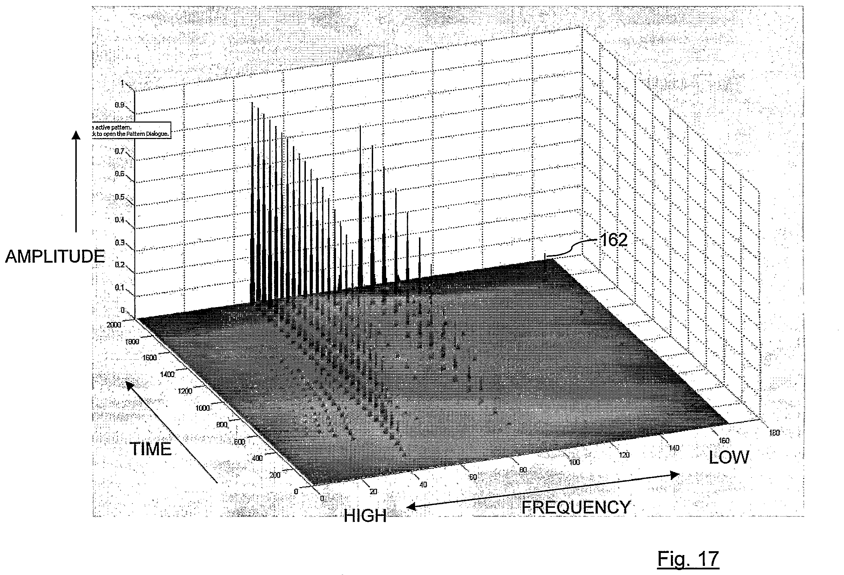

Figure 17 shows the result of data extraction on the topology of Figure 16. Each peak in the surface of Figure 16 that is a local peak in both the frequency and the time direction is rendered as a dot in space (as a function of the drawing package used they are shown as spikes upwards from a surface). One example is marked 162, which corresponds to the peak 160 in Figure 16. It can be seen from this Figure how curve fitting could now be used to join co-ordinates that represent the peaks identified. In this way the original signal is processed and represented in a totally new a manner.

The actual data extracted (the local peaks) can be used in many different ways, depending upon the application in which the signal analysis method is employed. For example, in testing environments such as medical testing (heart monitor for example) and equipment testing (vibration for example) specific characteristic in the analysed data of Figure 17 may be sought either using techniques such as neural networks or the like.

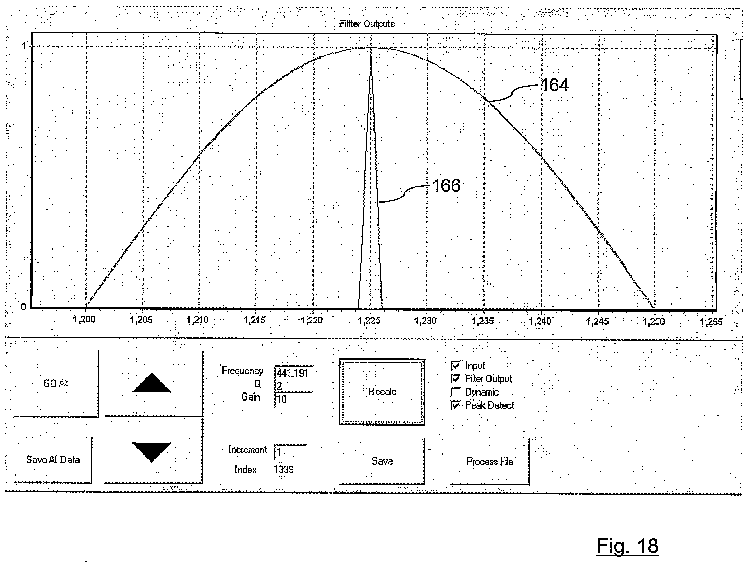

Figure 18 shows an example of the input, output and peak detect of a 6^{th} order bandpass filter with a Q of 2 and a centre frequency of 441.191 Hz in response to an input signal of 441.0 Hz. The input and output appear on top of each other as the phase and amplitude of input and output signals (labelled as 164) are almost co-incident. Where seen the difference is due to the 0.191 Hz difference between the input signal and the filters' centre frequency. The spike 166 is the peak detection for the output of the filter (the value of which is 1.00, which is difficult to detect with the naked eye), in the single time direction.

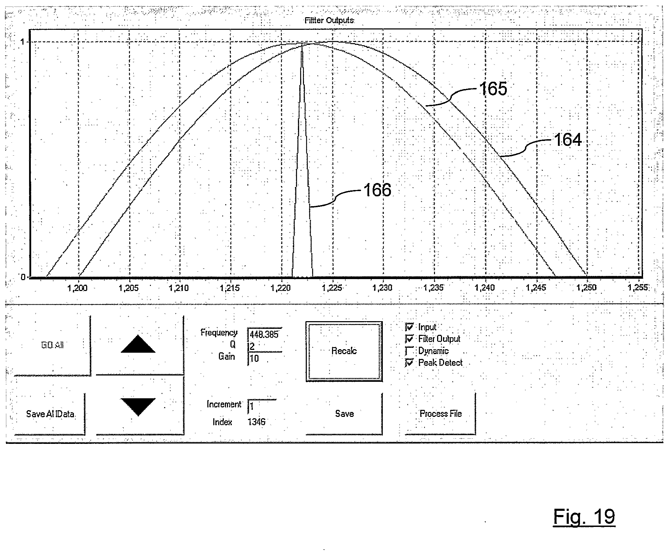

Figure 19 shows the input, output and peak detect of a second 6^{th} order bandpass filter with a Q of 2 and a centre frequency of 448.385Hz in response to the same input signal of 441.0 Hz. The input signal 164 and the output signal 165 are now obviously no longer coincident or in phase, and the value of the peak 166 is lower than 1 (the value is approximately 0.95, which is difficult to detect with the naked eye). The difference is due to the 7.385 Hz difference between the input signal and the filter's centre frequency. In respect of the detection of local peaks in both the time and frequency direction, the peak 166 of Figure 19 is not a local peak in both directions, because it has an amplitude below that of an adjacent filter, which is shown in Figure 18.

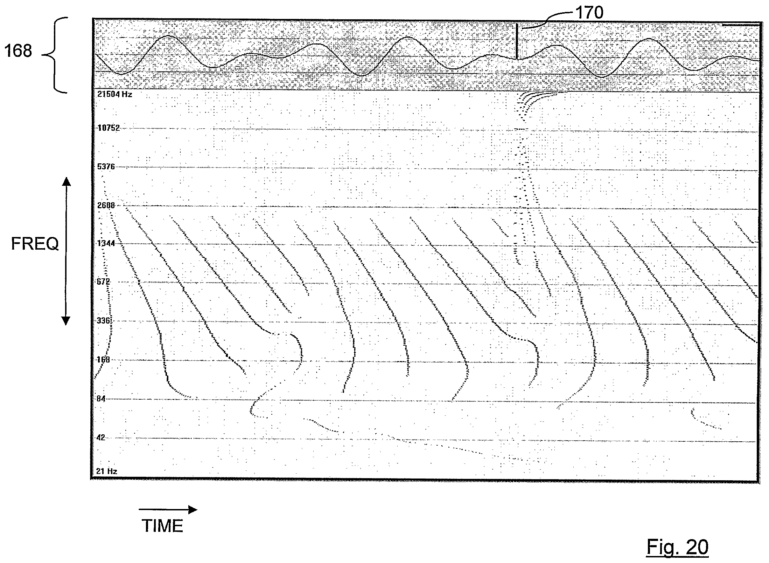

Figure 20 shows a signal comprised of 400 Hz and 600Hz sine waves plus a transient impact component, filtered using 12^{th} order lower resonance filters. The top portion 168 is the original signal with amplitude against time, showing the impact (such as a hand clap) shown at 170. Below this is the result of the data extraction technique, with each dot showing the presence of a detected local peak. The signal received is analysed in an impact mode, which differs slightly from the mode used for analysing periodic components in a signal. In the diagram of Figure 20, the local peaks identified include those that are local peaks relative to peaks that may have negative amplitude (i.e. that have a peak value below zero). The identified peaks are a peak relative to their surroundings and have positive amplitude. In the periodic analysis only local peaks that have adjacent peaks that have positive amplitude are identified. The impact 170 can be seen, in the Figure, as a series of lines travelling down in frequency. In impact mode lower Q filters are used, relative to the sinusoidal mode.

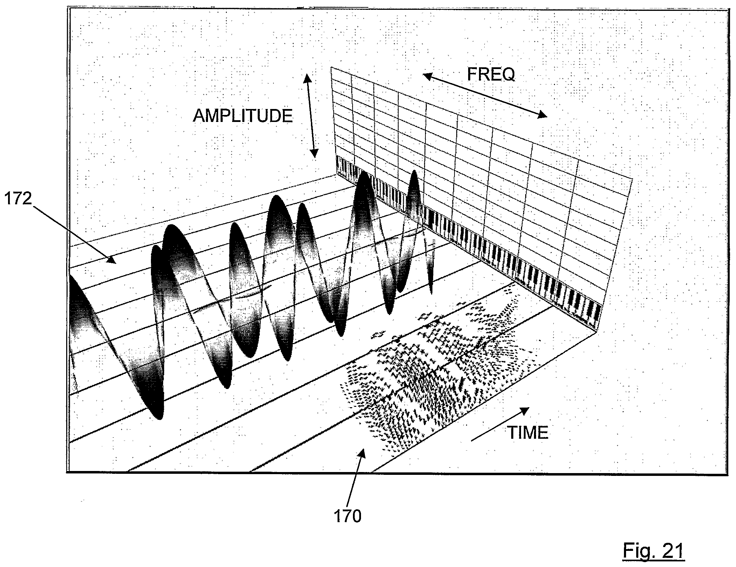

Figure 21 shows a sinusoidal reconstruction of the signal 168 of Figure 20, which is comprised of 400 Hz and 600Hz sine waves plus a transient impact component, using 6^{th} order high resonance filters. Note that the transient impact component 170 does not effect the sinusoidal re-construction of the sine waves 172.

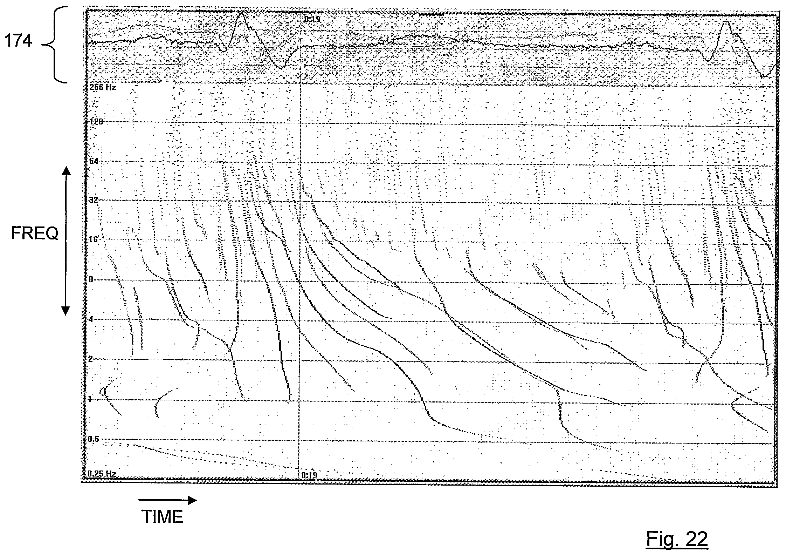

Figure 22 shows an analysis of a twelve lead ECG signal showing two of the leads in an original signal 174. The analysis has been performed individually on the two signals and the analysis overlayed. As in Figure 20, each dot shows the presence of a detected local peak. Curves can be seen travelling in frequency and time that indicate the nature of the electronic impact signals generated in the heart that make up the ECG signal. As can be seen from this Figure, in a practical application of the invention, a very large amount of information in the original signal can be identified using the data extraction technique described above.

In general, examples of analysis and/or processing of input signals by one or more and in any combination of apparatus described herein include, but are not restricted to, analysis-recognition-reconstruction, compression-reconstruction, processing-reconstruction, simulation-modelling-prediction-reconstruction and examples of these are given below.

Analysis/Recognition/Reconstruction examples include: radar, sonar, speech, text, instrument, musical score, translation, hearing correction, machine failure prediction, intruder detection, SETI, biological signals.

Compression/Reconstruction examples include: any single/multi sine signal including audio, tv, satellite, video, telecom.

Processing/Reconstruction examples include: filtering, pitch shifting, encryption/decryption, noise cancellation, signal removal, noise removal, signal correction (e.g. much more accurate hi - fi).

Simulation/Modelling/Prediction/Reconstruction examples include:
By combining arrays of these together (feeding the output of one to the input of another, etc), it will be possible to model any system, (up to the resolution of the "memory capacity" and "processor speed" of the system).

Simulating will allow for better prediction and hence have benefits in:- object guidance, weather prediction, geographic analysis, geological prospecting, planning, environmental disaster prediction, artificial intelligence, health/genetic engineering, food, animals, vegetables, diseases (viral/bacterial), pharmaceutical research, simulation (e.g. cancer growth), medical cures.

## Claims

1. A method of processing a signal (400) comprising receiving a signal (400), filtering the signal (400) with a plurality of band pass filters (401-406) of different frequencies, and extracting data from the output of the filters (401-406), the data extraction comprising identifying local peaks in the output of the filters (401-406), each local peak being a local peak in both the time and frequency directions, **characterised in that** each band pass filter (401-406) has a Q factor of at least 1/√2, and adjacent band pass filters (401-406), in the frequency sense, do not have the same Q factor.

2. A method according to claim 1, and further comprising executing a curve fitting procedure, the output of which procedure comprises curve data defining a curve that at least approximates to a portion of the extracted data.

3. A method according to claim 1 or 2, and further comprising varying the Q factor of at least one band pass filter (401-406) as the signal (400) is filtered.

4. A method according to any preceding claim, wherein the number of band pass filters (401-406) is variable, and the method further comprises varying the number of band pass filters (401-406) as the signal (400) is filtered.

5. A method according to any preceding claim, wherein the plurality of band pass filters (401-406) comprises approximately an integer multiple of twelve per frequency octave of the received signal (400).

6. A method according to any preceding claim, wherein the plurality of band pass filters (401-406) comprises approximately an integer multiple of three per component of the received signal (400).

7. A method according to claim 6, and further comprising tracking each component of the received signal (400) using a set of three band pass filters (401-406).

8. A system for processing a signal (400) comprising a receiver for receiving a signal (400), a plurality of band pass filters (401-406) of different frequencies for filtering the signal (400), and a processor arranged to extract data from the output of the filters (401-406), the data extraction comprising identifying local peaks in the output of the filters, each local peak being a local peak in both the time and frequency directions, **characterised in that** each band pass filter (401-406) has a Q factor of at least 1/√2, and adjacent band pass filters (401-406), in the frequency sense, do not have the same Q factor.

9. A system according to claim 8, wherein the processor is further arranged to execute a curve fitting procedure, the output of which procedure comprises curve data defining a curve that at least approximates to a portion of the extracted data.

10. A system according to claim 8 or 9, wherein the processor is further arranged to vary the Q factor of at least one band pass filter (401-406) as the signal (400) is filtered.

11. A system according to any one of claims 8 to 10, wherein the processor is further arranged to vary the number of band pass filters (401-406) as the signal (400) is filtered.

12. A system according to any one of claims 8 to 11, wherein the plurality of band pass filters (401-406) comprises approximately an integer multiple of three per component of the received signal (400).

13. A system according to claim 12, wherein the processor is further arranged to track each component of the received signal (400) using a set of three band pass filters (401-406).

## Patentansprüche

1. Verfahren zum Verarbeiten eines Signals (400), umfassend das Empfangen eines Signals (400), das Filtern des Signals (400) mit mehreren Bandpassfiltern (401-406) unterschiedlicher Frequenzen und das Extrahieren von Daten aus der Ausgabe der Filter (401-406), wobei die Datenextraktion das Identifizieren lokaler Spitzen in der Ausgabe der Filter (401-406) umfasst, wobei jede lokale Spitze sowohl in Zeit- als auch in Frequenzrichtung eine lokale Spitze ist, **dadurch gekennzeichnet, dass** jeder Bandpassfilter (401-406) einen Q-Faktor von mindestens 1/√2 aufweist und benachbarte Bandpassfilter (401-406) im Frequenzbereich nicht den gleichen Q-Faktor aufweisen.

2. Verfahren nach Anspruch 1, und ferner umfassend das Ausführen eines Kurvenanpassungsverfahrens, wobei die Ausgabe dieses Verfahrens Kurvendaten umfasst, die eine Kurve definieren, die mindestens einem Teil der extrahierten Daten entspricht.

3. Verfahren nach Anspruch 1 oder 2, und ferner umfassend das Variieren des Q-Faktors von mindestens einem Bandpassfilter (401-406), wenn das Signal (400) gefiltert wird.

4. Verfahren nach einem der vorhergehenden Ansprüche, wobei die Anzahl der Bandpassfilter (401-406) variabel ist und das Verfahren ferner das Variieren der Anzahl der Bandpassfilter (401-406) umfasst, wenn das Signal (400) gefiltert wird.

5. Verfahren nach einem der vorhergehenden Ansprüche, wobei die mehreren Bandpassfilter (401-406) etwa ein ganzzahliges Vielfaches von zwölf pro Frequenzoktave des empfangenen Signals (400) umfassen.

6. Verfahren nach einem der vorhergehenden Ansprüche, wobei die mehreren Bandpassfilter (401-406) etwa ein ganzzahliges Vielfaches von drei pro Komponente des empfangenen Signals (400) umfassen.

7. Verfahren nach Anspruch 6, und ferner umfassend das Verfolgen jeder Komponente des empfangenen Signals (400) unter Verwendung eines Satzes von drei Bandpassfiltern (401-406).

8. System zum Verarbeiten eines Signals (400), umfassend einen Empfänger zum Empfangen eines Signals (400), mehrere Bandpassfilter (401-406) mit unterschiedlichen Frequenzen zum Filtern des Signals (400) und einen Prozessor zum Extrahieren von Daten aus der Ausgabe der Filter (401-406), wobei die Datenextraktion das Identifizieren von lokalen Spitzen in der Ausgabe der Filter umfasst, wobei jede lokale Spitze sowohl in der Zeit- als auch in der Frequenzrichtung eine lokale Spitze ist, **dadurch gekennzeichnet, dass** jeder Bandpassfilter (401-406) einen Q-Faktor von mindestens 1/√2 aufweist und benachbarte Bandpassfilter (401-406) im Frequenzbereich nicht den gleichen Q-Faktor aufweisen.

9. System nach Anspruch 8, wobei der Prozessor ferner angeordnet ist, um ein Kurvenanpassungsverfahren auszuführen, wobei die Ausgabe dieses Verfahrens Kurvendaten umfasst, die eine Kurve definieren, die mindestens einem Teil der extrahierten Daten entspricht.

10. System nach Anspruch 8 oder 9, wobei der Prozessor ferner angeordnet ist, um den Q-Faktor von mindestens einem Bandpassfilter (401-406) zu variieren, während das Signal (400) gefiltert wird.

11. System nach einem beliebigen der Ansprüche 8 bis 10, wobei der Prozessor ferner angeordnet ist, um die Anzahl der Bandpassfilter (401-406) zu variieren, während das Signal (400) gefiltert wird.

12. System nach einem beliebigen der Ansprüche 8 bis 11, wobei die mehreren Bandpassfilter (401-406) etwa ein ganzzahliges Vielfaches von drei pro Komponente des empfangenen Signals (400) umfassen.

13. System nach Anspruch 12, wobei der Prozessor ferner angeordnet ist, um jede Komponente des empfangenen Signals (400) unter Verwendung eines Satzes von drei Bandpassfiltern (401-406) zu verfolgen.

## Revendications

1. Procédé de traitement d'un signal (400), comprenant la réception d'un signal (400), le filtrage du signal (400) avec une pluralité de filtres passe-bande (401-406) de différentes fréquences, et l'extraction de données de la sortie des filtres (401-406), l'extraction de données comprenant l'identification de crêtes locales dans la sortie des filtres (401-406), chaque crête locale étant une crête locale à la fois temporelle et fréquentielle, **caractérisé en ce que** chaque filtre passe-bande (401-406) a un facteur Q d'au moins 1/√2, et que les filtres passe-bande (401-406), dans la détection de fréquence, n'ont pas le même facteur Q.

2. Procédé selon la revendication 1, comprenant en outre l'exécution d'une procédure d'ajustement de courbe, la sortie de laquelle procédure comprenant des données de courbe définissant une courbe qui est approximativement équivalente à une section des données extraites.

3. Procédé selon la revendication 1 ou 2, comprenant en outre la variation du facteur Q d'au moins un filtre passe-bande (401-406) lorsque le signal (400) est filtré.

4. Procédé selon la revendication l'une quelconque des revendications précédentes, dans lequel le nombre de filtres passe-bande (401-406) est variable et le procédé comprend en outre la variation du nombre de filtres passe-bande (401-406) lorsque le signal (400) est filtré.

5. Procédé selon la revendication l'une quelconque des revendications précédentes, dans lequel la pluralité de filtres passe-bande (401-406) comprend approximativement un nombre entier multiple de douze par octave de fréquence du signal reçu (400).

6. Procédé selon la revendication l'une quelconque des revendications précédentes, dans lequel la pluralité de filtres passe-bande (401-406) comprend approximativement un nombre entier multiple de trois par composant du signal reçu (400).

7. Procédé selon la revendication 6, comprenant en outre le suivi de chaque composant du signal reçu (400) en utilisant un ensemble de trois filtres passe-bande (401-406).

8. Système de traitement d'un signal (400) comprenant un récepteur pour recevoir un signal (400), une pluralité de filtres passe-bande (401-406) de différentes fréquences pour filtrer le signal (400), et un processeur conçu pour extraire des données de la sortie des filtres (401-406), l'extraction de données comprenant l'identification de crêtes locales dans la sortie des filtres, chaque crête locale étant une crête locale à la fois temporelle et fréquentielle, **caractérisé en ce que** chaque filtre passe-bande (401-406) a un facteur Q d'au moins 1/√2, et que les filtres passe-bande (401-406), dans la détection de fréquence, n'ont pas le même facteur Q.

9. Système selon la revendication 8, dans lequel le processeur est en outre conçu pour exécuter une procédure d'ajustement de courbe, la sortie de laquelle procédure comprenant des données de courbe définissant une courbe qui est approximativement équivalente à une section des données extraites.

10. Système selon la revendication 8 ou 9, dans lequel le processeur est en outre conçu pour varier le facteur Q d'au moins un filtre passe-bande (401-406) lorsque le signal (400) est filtré.

11. Système selon l'une quelconque des revendications 8 à 10, dans lequel le processeur est en outre conçu pour varier le nombre de filtres passe-bande (401-406) lorsque le signal (400) est filtré.

12. Système selon l'une quelconque des revendications 8 à 11, dans lequel la pluralité de filtres passe-bande (401-406) comprend approximativement un nombre entier multiple de trois par composant du signal reçu (400).

13. Système selon la revendication 12, dans lequel le processeur est en outre conçu pour suivre chaque composant du signal reçu (400) en utilisant un ensemble de trois filtres passe-bande (401-406).
